**Europäisches Patentamt**

(19) **European Patent Office**

**Office européen des brevets**

(11) Veröffentlichungsnummer: **0 031 404**
**B1**

(12) **EUROPÄISCHE PATENTSCHRIFT**

(45) Veröffentlichungstag der Patentschrift:
09.04.86

(51) Int. Cl.⁴: **G 08 C 23/00**, G 08 C 19/24,
H 03 K 3/282

(21) Anmeldenummer: 80105892.6

(22) Anmeldetag: 29.09.80

(54) **Fernsteuerschaltung.**

(30) Priorität: 22.12.79 DE 2951974
22.12.79 DE 2951975
22.12.79 DE 2951976

(43) Veröffentlichungstag der Anmeldung:
08.07.81 Patentblatt 81/27

(45) Bekanntmachung des Hinweises auf die Patenterteilung:
09.04.86 Patentblatt 86/15

(84) Benannte Vertragsstaaten:
AT BE CH DE FR GB IT LI LU NL SE

(56) Entgegenhaltungen:
DE - A - 2 450 293
DE - A - 2 643 949
DE - A - 2 801 104
DE - B - 1 205 141
US - A - 2 788 449
US - A - 3 366 881
US - A - 3 488 586
US - A - 3 534 351
US - A - 4 152 696

ELECTRICAL DESIGN NEWS, Band 9, Heft 13,
November 1964, US H. GREENE: "Complementary
Multi-vibrator", Seiten 54 und 55
ELECTRONIQUE INDUSTRIELLE, Heft 61, Februar 1963,

(73) Patentinhaber: Voll, Walter, Ing. grad.,
Nikolaus-Fey-Strasse 2, D-8728 Hassfurt (DE)

(72) Erfinder: Voll, Walter, Ing. grad., Nikolaus-Fey-Strasse 2,
D-8728 Hassfurt (DE)

(74) Vertreter: Gaiser, Hartmut, Dipl.-Ing., Sulzbacher
Strasse 39, D-8500 Nürnberg 20 (DE)

(56) Entgegenhaltungen: (Fortsetzung)
PARIS (FR) C.D.: "Télémesure à terme unique", Seiten
76-79
"Infrafern - das Baugruppensystem für Infrarot
Fernbedienungen" Publiziert am Juni 1979, SIEMENS
AG BERLIN und MÜNCHEN (DE)
E.L.O., Heft 12, Dezember 1979, MÜNCHEN (DE)
FINDEISEN: "Fern-Licht-Schalter", Seiten 80-83

EP 0 031 404 B1

## Beschreibung

## Fernsteuerschaltung

Die Erfindung betrifft eine Fernsteuerschaltung mit den Merkmalen im Oberbegriff des Anspruchs 1.

Eine derartige Schaltung ist in der US-A-4 169 226 beschrieben. Um unterschiedliche Impulspausendauern einschalten zu können, ist neben einem Vorwahlschalter ein Ein-Ausschalter nötig. Ohne diesen Schalter würde der Sender ständig Strom verbrauchen. Nachteilig ist dieser Schalter, da er ein zusätzliches Bauteil ist, das so ausgelegt sein muß, daß es den gesamten Sendestrom schalten kann. Bei der Benutzung ist ungünstig, daß sowohl dieser Schalter als auch der Vorwahlschalter betätigt werden muß.

In der Literaturstelle Electronique Industrielle, Heft 61, Februar 1983, Paris, Seiten 76 bis 79 ist keine Fernsteuerschalter, sondern eine Fermeßschaltung beschrieben, die zum Empfang von sich kontinuierlich ändernden Meßwerten vorgesehen ist. Ein Stromverbrauch des Senders liegt auch während der Impulspausen vor, weil der Sender eine Trägerfrequenz abstrahlt. Im Empfänger werden entweder die Spitzenwerte oder die Nullspannungsdurchgänge einer Sägezahnspannung ausgewertet. Eine Mittelwertbildung der Sägezahnspannung und eine zugeordnete Spannungspegelauswertestufe ist hier nicht vorzusehen.

Eine ähnliche Schaltung ist in der DE-A-28 01 104 beschrieben. Nachteilig ist bei dieser Schaltung der aufwendige Aufbau. Dieser ist empfängerseitig durch eine aufwendige Dekodierung der Impulspausen bedingt. Senderseitig ist der Aufbau aufwendig, weil bei der DE-A-28 10 104 eine Unterdrückung von Instabilitäten nach der Betätigung eines der Schalter nötig ist.

In der Zeitschrift ELO 1979, Heft 12, Seiten 80 bis 83 ist ein Fernsteuer-Infrarot-Schalter beschrieben, mit dem die Fernsteuerung einer Garagentür möglich ist. Die Sendeschaltung arbeitet mit einem astabilen Multivibrator, der sich zwischen zwei Frequenzen umstellen läßt. Für die Erzeugung der Sendeimpulse ist ein Darlington-Verstärker vorgesehen. Im Sender ist ein weiterer Schalter zur Bereitstellung der Versorgungsspannung für eine kurze Zeit angeordnet. Die Empfängerschaltung arbeitet mit einem Bandpaß und weiteren Bauteilen. Der Aufbau auch dieser Fernsteuerschaltung ist aufwendig und damit in ihren Einsatzmöglichkeiten beschränkt. Die Impulspausen spielen für die Kodierung der beiden zu schaltenden Funktionen keine wesentliche Rolle. Der beschriebene Empfänger zeigt keine Dekodiermöglichkeit für die zwei schaltbaren Funktionen.

In der Zeitschrift Bauteile-Report 17 (1979, Heft 5, Seiten 189 bis 191) ist eine Einkanal-Infrarot-Fernsteurung beschrieben. Der Sender arbeitet hier mit einem aus NAND-Gattern aufgebauten

Oszillator und mit einem Darlington-Verstärker. Im Empfänger werden die ankommenden Sendeimpulse integriert, bis eine bestimmte Schwellenspannung überschritten ist. Auch bei dieser als einfach bezeichneten Schaltung ist noch relativ hoher Aufwand an elektronischen Bauteilen nötig.

In der US-A-3 534 351 ist eine Fernwirkeinrichtung beschrieben, bei der ein Sender ständig eine Lichtimpulsfolge in einem Raum abstrahlt. Der Empfänger spricht an, wenn die übertragungsstrecke unterbrochen wird. Dementsprechend weist der Sender keinen manuell zu betätigenden Schalter auf. Er ist jedoch an sich einfach aufgebaut und arbeitet mit geringem Stromverbrauch, da die einmal festgelegten Sendeimpulse kurz gegenüber den einmal festgelegten Impulspausen sind. Im Empfänger ist ein monostabiler Multivibrator vorgesehen, der vor jedem empfangenen Impuls angestoßen wird und während der Impulspause einen Kondensator auf einem so niedrigen Spannungswert hält, daß eine nachgeschaltete Schwingschaltung nicht aqnspricht. Der Kondensator lädt sich erst dann auf einen Wert, bei dem die Schwingschaltung anspricht, wenn die Empfangsimpulse ausfallen. Die Dauer der Impulspause überträgt also keine Information. Vielmehr muß im Empfänger die für den Sender an sich vorteilhafte lange Impulspausendauer unterdrückt werden, um nicht ein Schalten der Schwingschaltung herbeizuführen.

In der DE-A-23 40 978 ist ein Sender für eine Wechsellichtschranke beschrieben. Der Sender weist zwei komplementäre Transistoren auf. Der Kollektor des ersten Transistors liegt über einen Widerstand an der Basis des zweiten Transistors. Der Kollektor des zweiten Transistors liegt an einem Sendebauteil und über ein RC-Glied an der Basis des ersten Transistors. Ein weiterer Transistor ist zur genauen Einstellung von Impulspause und Impulsdauer vorgesehen. Bei diesem Sender ist es weder möglich noch erforderlich, unterschiedliche Impulspausendauern bei unveränderter Impulsdauer über Handschalter einzustellen.

Bei Geräten, bei denen nur wenige, beispielsweise 2 bis 10 Funktionen zu schalten sind, besteht der Wunsch, diese Funktionen mit einer möglichst preisgünstigen Fernsteuerschaltung zu schalten.

Es ist Aufgabe der Erfindung, eine Fernsteuerschaltung der eingangs genannten Art vorzuschlagen, die in ihrem Aufbau hinsichtlich der notwendigen Bauteile weitgehend optimiert ist, mit einer im Hinblick auf den Aufbau einfachen Kodierung und Dekodierung arbeitet und, insbesondere im Sender, einen geringen Stromverbrauch aufweist.

Erfindungsgemäß ist obige Aufgabe bei einer Fernsteuerschaltung der eingangs genannten Art durch die Merkmale im kennzeichnenden Teil des Anspruchs 1 gelöst.

Diese Fernsteuerschaltung weist zahlreiche Vorteile auf:

auszugehen, daß der manuell betätigte Tastschalter nach Beendigung des ersten Sendeimpulses der Diode D1 noch geschlossen ist. Es wird nun der Kondensator C2 über den dem jeweils geschlossenen Schalter S1 bis S4 in Reihe liegenden Widerstand R3 bis R6 entladen. Die Impulspause ist durch die Dauer dieses Entladevorgangs bestimmt.

Nimmt man an, daß der betreffende Schalter S1 bis S4 länger geschlossen ist als die Entladung des Kondensators C2 über den betreffenden Widerstand R3 bis R6 dauert, dann tritt nach der Entladung des Kondensators C2 das nächste Durchschalten der Transistoren T1 und T2 auf. Bei einem über längere Zeit, beispielsweise 1 s, geschlossenen Schalter S1 bis S4 bestimmt damit der Widerstandswert des betreffenden Widerstands R3 bis R6 die Dauer der Impulspause zwischen zwei Sendeimpulsen.

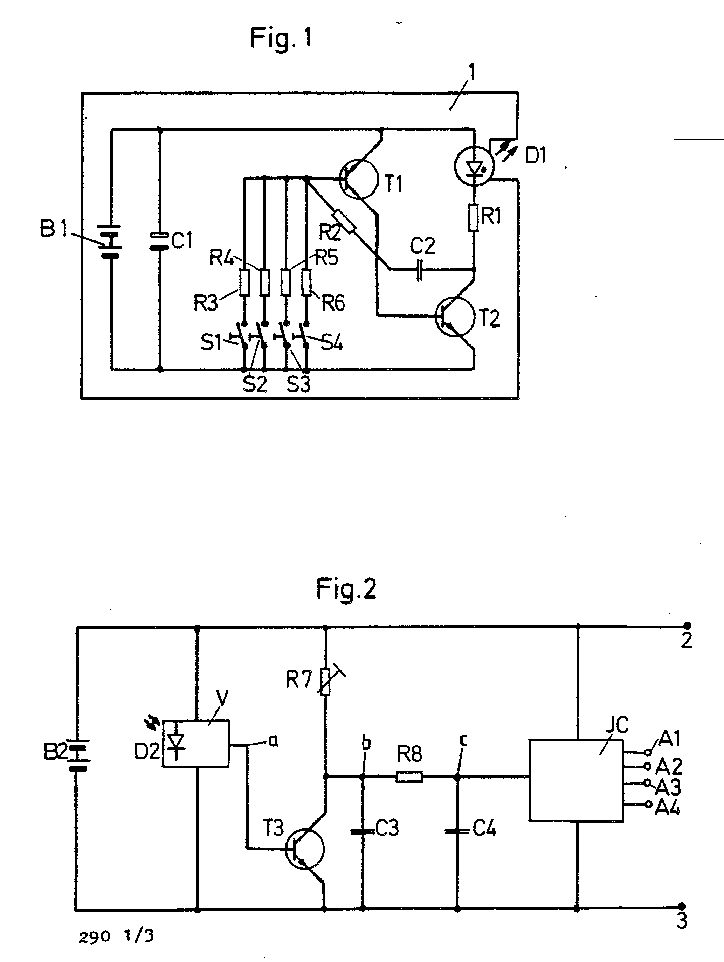

Die in Figur 2 dargestellte Empfangsschaltung ist in dem fernzusteuernden Gerät untergebracht. Handelt es sich um ein batteriebetriebenes Gerät, wie beispielsweise ein Spielzeugauto, dann ist eine Batterie B2 vorgesehen, welche die Antriebsleistung für das Gerät bringt. Im Falle eines Projektors für Diapositive, der mit dem Netz verbunden ist, kann anstelle der Batterie ein entsprechender Gleichrichter vorgesehen sein.

Die von der Infrarot-Diode D1 abgestrahlten Infrarot-Impulse weisen - wie beschrieben - unterschiedliche Impulspausen auf, je nachdem ob der Schalter S1, S2, S3 oder S4 betätigt wurde. Die Empfangsschaltung nach Figur 2 arbeitet mit einer Infrarot-Empfangsdiode D2, an die ein Vorverstärker V angeschlossen ist. Am Ausgang des Vorverstärkers V tritt eine hinsichtlich der Impulspausen der Infrarot-Diode D1 gleiche Impulsfolge auf.

Der Ausgang des Vorverstärkers V ist an die Basis eines Transistors T3 gelegt. Die Kollektor-Emitter-Strecke des Transistors T3 liegt parallel zum Kondensator C3 eines RC-Ladekreises R7, C3, der parallel zur Batterie B2 angeschlossen ist.

An den Abgriff zwischen dem Kondensator C3 und dem Widerstand R7 ist eine Siebschaltung, bestehend aus einem Widerstand R8 und einem Kondensator C4 angeschlossen. Deren Ausgang liegt an einer Spannungspegel-Auswertestufe JC. Diese ist beispielsweise von einem integrierten Bauelement UAA 170 (Siemens) gebildet. Sind vier Widerstände R3 bis R6 bzw. Schalter S1 bis S4 im Sender vorgesehen, dann wird dementsprechend eine Spannungspegel-Auswertestufe JC eingesetzt, die ebenfalls vier verschiedene Spannungswerte am Eingang auswertet und einen von vier Ausgängen A1 bis A4 schaltet.

An Pole 2 und 3 der Empfangsschaltung nach Figur 2 ist die nicht näher dargestellte, an sich bekannte Antriebsschaltung des zu steuernden Geräts angeschlossen.

Die Funktionsweise der beschriebenen Empfangsschaltung nach Figur 2 ist etwa folgende:

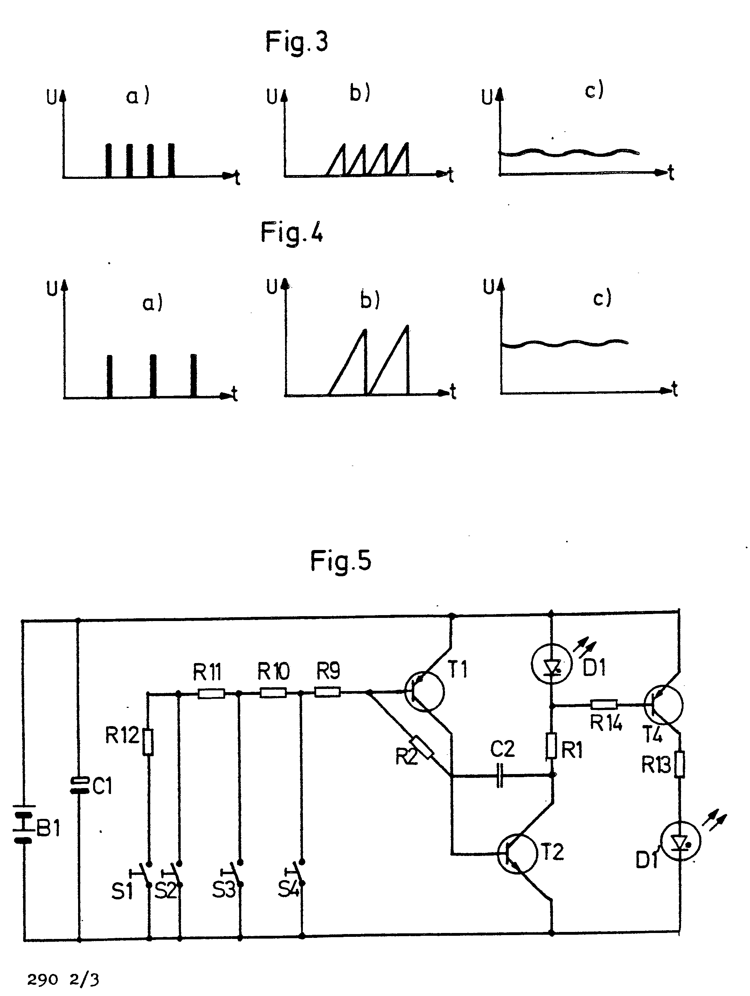

Empfängt die Infrarot-Diode D2 von der Diode D1 des Senders (vgl. Figur 1) kommende Impulse, dann wird der Transistor T3 bei jedem der Impulse leitend geschaltet. In Figur 3a und in Figur 4a sind Sende-bzw. Empfangsimpulse mit unterschiedlichen Impulspausen dargestellt. Wenn der Transistor T3 leitend geschaltet wird, dann entlädt er den Kondensator C3. Danach wird aus der Batterie B2 über den Widerstand R7 der Kondensator C3 wieder aufgeladen (vgl. Figur 3b und Figur 4b). Die Aufladung erfolgt nach einer e-Funktion. Der Widerstand R7 und der Kondensator C3 sind so bemessen, daß im Rahmen der von dem Sender zu erwartenden Impulsfolge der Kondensator C3 immer nur teilweise geladen wird, so daß bei einem nächstfolgenden Impuls die Ladung des Kondensators C3 wieder entladen wird. Es entsteht damit eine Sägezahnspannung am Abgriff (vgl. Figur 3b und Figur 4b). Die Dauer des Aufladevorgangs des Kondensators C3 und damit auch die Amplitude der Sägezahnspannung hängen von den Impulspausen ab. Die Sägezahnspannung am Abgriff wird mittels des Widerstandes R8 und des Kondensators C4 gesiebt, so daß am Eingang der Spannungspegel-Auswertestufe JC eine Gleichspannung mit geringer Restwelligkeit auftritt (vgl. Figur 3c und Figur 4c). Die Größe der Gleichspannung hängt von der Sägezahnspannung am Abgriff und damit von den Impulspausen der Sendediode D1 ab. Entsprechend dem jeweils am Eingang auftretenden Gleichspannungswert schaltet einer der Ausgänge A1 bis A4 durch und steuert damit die entsprechende Funktion des Gerätes an. Sind vier Funktionen bei einem ferngesteuerten Spielzeugfahrzeug zu steuern, dann handelt es sich beispielsweise um einen Lenkeinschlag nach rechts oder nach links und einen Antrieb vorwärts oder rückwärts. Sind vier Funktionen bei einem Diaprojektor zu steuern, dann handelt es sich beispielsweise um die Steuerungen Vorwärtstransport oder Rückwärtstransport und Vorschub oder Rückschub der Optik des Projektors zur Scharfeinstellung.

Im Rahmen der Erfindung liegen zahlreiche weitere Ausführungsbeispiele. So ist es beispielsweise möglich, den Sender entsprechend Figur 5 aufzubauen. Bei dem Sender nach Figur 5 sind anstelle der parallelliegenden Widerstände R3 bis R6 nach Figur 1 in Serie geschaltete Widerstände R9 bis R12 vorgesehen. Die Schalter S1 bis S4 liegen jeweils zwischen einem der Widerstände und einem Pol der Batterie. Wird beispielsweise der Schalter S1 geschlossen, dann hängt die Dauer der Impulspause und damit das Tastverhältnis von der Summe der Widerstände R9 bis R12 ab. Wird der Schalter S4 geschlossen, dann hängt die Dauer der sich einstellenden Impulspause lediglich vom Widerstand R9 ab. Entsprechendes gilt für die anderen Schalter. Günstig dabei ist, daß der jeweils in Figur 5 weiter rechts liegende Schalter gegenüber den weiter links liegenden Schaltern Vorrang hat, so daß dann, wenn beispielsweise der Schalter S4 und einer oder mehrere der Schalter S1, S2 und S3 gleichzeitig

a)

Die Sendeimpulse können im Vergeich zur Impulspause sehr kurz sein. Die Länge der Sendeimpulse liegt beispielsweise im Bereich von 10 bis 50 µs. Der das Sendebauteil, insbesondere eine Infrarotdiode, durchfließende Strom kann dabei sehr hoch sien, beispielsweise 2,5 A. Trotz dieses hohen Stromes ist der Leistungsverbrauch des Senders gering, da die Stromflußzeiten kurz sind und während der Impulspausen praktisch kein Strom fließt.

b)

Im Sender ist zur Kodierung jeder zu steuernden Funktion lediglich ein das Tasverhältnis änderndes Bauteil, beispielsweise ein Widerstand, und ein Schalter, beispielsweise ein Tastschalter, notwendig.

c)

Im Sender übernimmt der Multivibrator sowohl die Impulserzeugung als auch die Verstärkerfunktion, so daß diese beiden Funktionen nicht durch eigene Baugruppen erzeugt werden müssen.

d)

Die Schalter brauchen nicht den hohen Sendeimpulsstrom zu schalten. Es können deshalb einfache Schalter eingesetzt werden, die nicht für hohe Ströme geeignet sind.

e)

Durch die Kodierung der zu schaltenden Funktionen über die Impulspausen wird der Stromverbrauch im Sender trotz Steuerung mehrerer Funktionen nicht wesentlich beeinflußt. Vielmehr haben Impulsfolgen mit längeren Impulspausen einen geringeren Stromverbrauch zur Folge.

f)

Im Empfänger können auch solche Impulsfolgen sicher ausgewertet werden, bei denen das Tastverhältnis sehr klein ist, die Impulse beispielsweise 30 µs und die Impulspausen beispielsweise etwa 3 ms, betragen, da die Impulse nicht integriert werden, sondern jeder Impuls den nach einer e-Funktion verlaufenden Ladevorgang des Kondensators des RC-Ladekreises unterbricht. Die dabei auftretende Sägezahnspannung ist einfach zu sieben. Die Ausgangsspannung der Siebstufe läßt sich mit einer handelsüblichen Spannungspegel-Auswertestufe erfassen.

In bevorzugter Ausgestaltung der Erfindung sind die die Impulspausen bestimmenden Bauteile parallel an die Basis des ersten Transistors angeschlossene Widerstände, zu denen die Schalter in Reihe liegen.

Dabei können die Widerstände hochohmig sien, d.h. im MΩ-Bereich liegen. Dies hat den Vorteil, daß die Schalter nur zur Schaltung eines sehr niedrigen Stromes ausgelegt werden müssen. Außerdem läßt sich damit im RC-Glied des Senders ein sehr kleiner Kondensator, beispielsweise 10 nF, einsetzen.

Weitere vorteilhafte Ausgestaltungen der Erfindung ergeben sich aus der folgenden Beschreibung und den abhängigen Ansprüchen.

In der Zeichnung zeigen:

Figur 1 ein Ausführungsbeispiel einer vollständigen Schaltung des Senders zur Steuerung mehrerer Funktionen,

Figur 2 eine vollständige Schaltung des Empfängers,

Figuren 3 und 4 verschiedene Spannungsdiagramme der Empfängerschaltung,

Figur 5 ein weiteres Ausführungsbeispiel des Sendeschaltung zur Steuerung mehrerer Funktionen,

Figur 6 eine Sendeschaltung mit zusätzlicher Kodierungsmöglichkeit,

Figur 7 eine Empfängerschaltung für den Sender nach Figur 6.

Die Schaltung des Senders 1 nach Figur 1 ist in einem handlichen Gehäuse untergebracht. In dem Gehäuse ist eine Batterie B1, beispielsweise eine 9V-Batterie, untergebracht. An dem Gehäuse sind vier Tastschalter S1 bis S4 angeordnet. Das Gehäuse weist außerdem eine Öffnung auf, durch die eine Infrarot-Diode D1 nach außen strahlt.

Parallel zur Batterie B1 liegt ein Kondensator C1, der die hohen Stromspitzen liefert. An den Polen der Batterie B1 liegen außerdem die Emitter von zwei komplementären Transistoren T1 und T2. Der Kollektor des Transistors T1 ist mit der Basis des Transistors T2 direkt (vgl. Figur 1) oder über einen Widerstand verbunden. An den Kollektor des Transistors T2 ist über einen Vorwiderstand R1 die Infrarot-Diode D1 angeschlossen. Der Kollektor des Transistors T2 ist außerdem über einen Kondensator C2 und einen Widerstand R2 mit der Basis des Transistors T1 verbunden. An die Basis des Transistors T1 sind über Widerstände R3 bis R6, die unterschiedliche Widerstandswerte aufweisen, die Tastschalter S1 bis S4 angeschlossen (vgl. Figur 1).

Die Widerstandswerte der Widerstände R3 bis R6 liegen z.B. im MΩ-Bereich. Der Widerstand R2 liegt z.B. im kΩ-Bereich. Die Kapazität des Kondensators C2 liegt beispielsweise im Bereich von 10 nF.

Die Funktion des Senders ist etwa folgende:

Wird einer der Tastschalter S1 bis S4 betätigt, dann fließt über den betreffenden Widerstand R3 bis R6 ein Basisstrom über den Transistor T1. Ein entsprechend dem Verstärkungsfaktor des Transistors T1 verstärkter Strom fließt dadurch über die Basis des Transistors T2. Der Transistor T2 schaltet. Damit erfolgt über den Kondensator C2 und den Widerstand R2 eine Rückkopplung auf die Basis des Transistors T1, so daß dieser schlagartig durchschaltet. Gleichzeitig fließt über den Widerstand R1 und die Infrarot-Diode D1 ein hoher Strom, beispielsweise in der Größenordnung von 1 A bis 2,5 A. Sobald der Kondensator C2 geladen ist, sinkt der über den Widerstand R2 fliessende Strom, so daß sich der über den Widerstand R1 und die Diode D1 fließende Strom so vermindert, daß der Ausgangs-Lichtimpuls der Diode D1 endet. Beide Transistoren T1 und T2 sind gesperrt. Die Dauer des die Leuchtdiode D1 durchfließenden Stromimpulses liegt im Bereich von 10 bis 50 µs. Dementsprechend ist davon geschlossen werden, sich die allein durch den Widerstand R9 bestimmte Sendeimpulsfolge einstellt. Demgegenüber stellt sich bei der Parallelschaltung der Widerstände R3 bis R6 nach Figur 1 dann, wenn zwei oder mehr der Schalter gleichzeitig betätigt werden, eine Sendeimpulsfolge ein, deren Tastverhältnis durch die Werte der parallelgeschalteten Widerstände der jeweils geschlossenen Schalter bestimmt ist. Durch eine geeignete Dimensionierung der Widerstände R3 bis R6 und eine entsprechende Auslegung der Spannungspegel-Auswertestufe JC kann erreicht werden, daß die gleichzeitige Betätigung zweier oder mehr der Schalter S1 bis S4 eine oder mehrere weitere Funktionen des Geräts schaltet. Bei einer solchen Auslegung lassen sich dann also mehr Funktionen schalten als Schalter S1 bis S4 vorgesehen sind. Beispielsweise können mit drei Schaltern und drei Widerständen sechs Funktionen geschaltet werden, wenn das gleichzeitige Betätigen zweier Schalter vorgesehen ist. Sieben Funktionen lassen sich schalten, wenn die Schaltung so ausgelegt ist, daß das Schließen aller drei Schalter zur Steuerung einer weiteren Funktion führt.

Zur Einstellung unterschiedlicher Impulspausen lassen sich auch mehrere parallel oder in Reihe geschaltete Kondensatoren C2 vorsehen, die durch den Schaltern S1 bis S4 entsprechende Schalter einschaltbar sind. Um in diesem Fall den Stromverbrauch niedrig zu halten, sollte zusätzlich ein Ein-Aus-Schalter vorgesehen sein.

Anstelle der einen Sendediode D1 können auch zwei oder mehr Sendedioden in Reihe oder parallel geschaltet vorgesehen sein. Falls die Spannung der Batterie B1 nicht hoch genug ist, die Sendedioden in Reihe geschaltet zu betreiben und die Belastbarkeit des Transistors T2 nicht hoch genug ist, die Sendedioden parallel zu betreiben, wird die zweite Sendediode D1' mit einem Widerstand R13 in Reihe zur Emitter-Kollektor-Strecke eines weiteren Transistors T4 geschaltet, dessen Basis über einen Widerstand R14 mit der ersten Sendediode D1 verbunden ist (vgl. Figur 5).

Im Rahmen der Erfindung können auch anstelle der Infrarot-Sendediode D1 und der Empfangsdiode D2 andere Sende- und Empfangsbauteile eingesetzt werden. Beispielsweise können Niederfrequenz-Schwingkreise unter 10 kHz, oder Hochfrequenz-Schwingkreise im CB-Band vorgesehen sein.

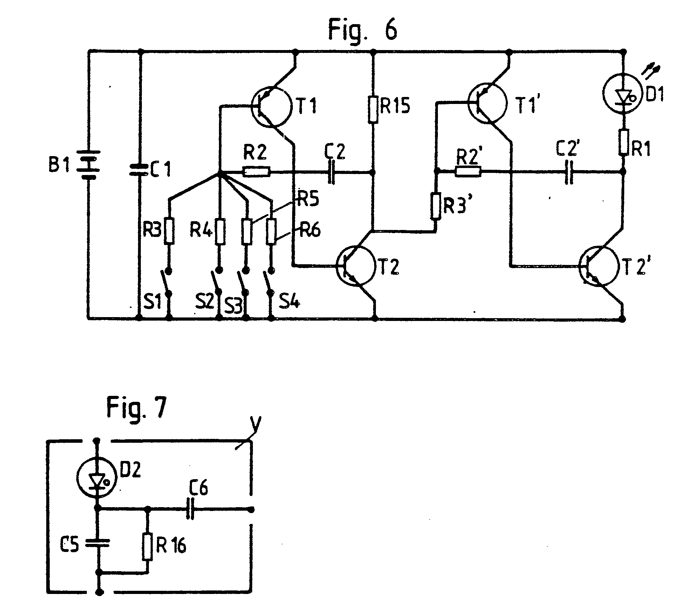

In Figur 6 ist ein Sender dargestellt, der nicht einzelne Impulse entsprechend Figur 3, sondern Impulspakete erzeugt. Im Prinzip ist hier die Schaltung nach Figur 1 zweimal hintereinander geschaltet. Den Transistoren T1 und T2 entsprechen die Transistoren T1' und T2'. Dem RC-Glied R2 und C2 entspricht das RC-Glied R2' und C2'. Der Widerstandschaltung R3, R4, R5, R6 entspricht der Widerstand R3'. Die Schalter S1 bis S4 liegen in Reihe zu den Widerständen R3 bis R6. Zwischen dem Kollektor des Transistors T2 und der Batterie B1 ist ein Widerstand R15 vorgesehen. Die Dimensionierung der Zeitkonstanten des Lade- und Entladevorgangs des Kondensators C2' einerseits und des Kondensators C2 andererseits weicht voneinander ab. Die Dimensionierung des Kondensators C2, des Widerstands R2 und der Widerstände R3 bis R6 ist nach den anhand der Figuren 1 bis 3 beschriebenen Grundsätzen vorgenommen, also so, daß der Transistor T2 wesentlich länger sperrt als leitet. Solange der Transistor T2 durchgeschaltet ist, strahlt die Infrarot-Diode D1 ein Impulspaket ab. Es sind hierfür die von den Widerständen R2' und R3' und dem Kondensator C2, bestimmten Zeitkonstanten entsprechend kurz gewählt. Die Impulspakete können bei einer entsprechenden Dimensionierung des Widerstands R3' ein Tastverhältnis von etwa 1 annehmen. Damit treten anstelle jedes der in Figur 3a oder Figur 4a dargestellten Einzelimpulse zwischen den Impulspausen mehrere Impulse (Impulspaket) auf. Durch die Schaltung nach Figur 6 ist es möglich, die Anzahl der Sendeimpulse zwischen den Impulspausen zu erhöhen.

In Figur 7 ist ein Verstärker V gezeigt, der sich an der Empfängerschaltung nach Figur 2 einschalten läßt. Der Empfangsdiode D2 ist ein Filter aus einem Kondensator C5 und einem Widerstand R16 nachgeschaltet. Mit einem Koppelkondensator C6 ist die Infrarot-Diode D2 an den Transistor T3 angeschlossen. Das Filter C5, R16 ist auf die Frequenz der Impulspakete abgestimmt. Ein Empfänger, dessen Filter auf eine andere Frequenz, als die des Impulspaketes eines Senders eingestellt ist, kann also auf diesen nicht ansprechen. Es ist damit möglich, in räumlicher Nähe mehrere Empfänger und mehrere Sender so zu betreiben, daß ein Empfänger immer nur auf einen Sender anspricht. Außerdem ist eine verbesserte Störunempfindlichkeit und eine größere Reichweite möglich.

Der Empfänger nach Figur 2 arbeitet mit einer Batterie. Wenn das Gerät, dessen Funktionen zu schalten sind, am elektrischen Netz liegt, empfiehlt es sich, die Versorgungsspannung für die Empfängerschaltung aus dem Netz abzuleiten. Hierfür kann eine Gleichrichterdiode, ein Vorwiderstand, ein Siebkondensator und eine Zenerdiode zur Spannungsstabilisierung vorgesehen sein.

**Patentansprüche**

1. Fernsteuerschaltung, insbesondere Infrarot-Fernsteuerschaltung, zur Steuerung mehrerer Funktionen eines Geräts, beispielsweise Spielfahrzeuges oder Diaprojektors, mit einem ein- und ausschaltbaren Sender (1), der einen Impulsgenerator und eine der Anzahl der zu steuernden Funktionen (A1 bis A4) entsprechende Anzahl von unterschiedliche Impulspausendauern bei unveränderter Impulsdauer bestimmenden Bauteilen (R3 bis R6; R9 bis R12) aufweist, die mit je einem Schalter (S1 bis S4) einschaltbar sind, und mit einem Empfänger (Figur 2), der die Impulspausendauer auswertet, wobei der Sender als Multivibrator aus zwei Transistoren (T1, T2) aufgebaut ist, bei dem der Kollektor des ersten Transistors an der Basis des zweiten Transistors liegt, dessen Kollektor über ein RC-Glied (C2, R2) an der Basis des ersten Transistors (T1) liegt, und an die Basis des ersten Transistors (T1) die die Impulspausendauern bestimmenden Bauteile (R3 bis R6; R9 bis R12) angeschlossen sind, dadurch gekennzeichnet, daß der Sender (1) aus komplementären Transistoren (T1, T2) aufgebaut ist und daß das Sendebauteil (D1) am Kollektor des zweiten Transistors (T2) liegt, wobei jeder der Schalter (S1 bis S4) den Sender (1) ein- bzw. ausschaltet, daß der Empfänger (Figur 2) einen RC-Ladekreis (R7, C3) aufweist, dessen Kondensator (C3) sich während der Impulspause über dessen Widerstand (R7) lädt und bei Empfang eines Sendeimpulses entladen wird, so daß eine Sägezahnspannung (Figur 3b, 4b) entsteht, deren Perioden den empfangenen Impulspausen (Figur 3a, 4a) entsprechen und deren Amplitude demzufolge der Impulspausendauer entspricht, und daß dem RC-Ladekreis (R7, C3) eine Siebstufe (R8, C4) nachgeschaltet ist, die aus den Amplituden der Sägezahnspannung einen Spannungspegel bildet, und daß der Siebstufe (R8, C4) eine Spannungspegelauswertestufe (JC) nachgeschaltet ist, die dann je eine der Funktionen steuert, wenn der anstehende Spannungspegel einem Spannungspegel aus einer Anzahl von Spannungspegeln entspricht, die der Anzahl der die Impulspausen bestimmenden Bauteile entspricht.

2. Fernsteuerschaltung nach Anspruch 1, dadurch gekennzeichnet, daß die die Impulspausen bestimmenden Bauteile parallel an die Basis des ersten Transistors (T1) angeschlossene Widerstände (R3 bis R6) sind, zu denen die Schalter (S1 bis S4) in Reihe liegen.

3. Fernsteuerschaltung nach Anspruch 1, dadurch gekennzeichnet, daß die die Impulspausen bestimmenden Bauteile in Reihe an die Basis des ersten Transistors (T1) angeschlossene Widerstände (R9 bis R12) sind und daß die Schalter (S1 bis S4) jeweils zwischen einem der Widerstände (R9 bis R12) und dem Emitter des zweiten Transistors (T2) liegen.

4. Fernsteuerschaltung nach einem der vorhergehenden Ansprüche, dadurch gekennzeichnet, daß das Sendebauteil von einer oder mehreren Infrarot-Dioden (D1, D1') gebildet ist.

5. Fernsteuerschaltung nach einem der vorhergehenden Ansprüche, dadurch gekennzeichnet, daß an den Kollektor des zweiten Transistors (T2) eine Infrarot-Diode (D1) mit einem Vorwiderstand (R1) in Reihe geschaltet ist.

6. Fernsteuerschaltung nach einem der vorhergehenden Ansprüche, dadurch gekennzeichnet, daß im Empfänger parallel zum Kondensator (C3) des RC-Ladekreises (R7, C3) die Kollektor-Emitter-Strecke eines Transistors (T3) liegt, an dessen Basis über einen Vorverstärker (V) das Empfangsbauteil (D2) angeschlossen ist.

7. Fernsteuerschaltung nach einem der vorhergehenden Ansprüche, dadurch gekennzeichnet, daß der Sender (1) einen zweiten Multivibrator (T1', T2') umfaßt, wobei die Basis des ersten Transistors (T1') über einen Widerstand (R3') am Kollektor des zweiten Transistors (T2) des ersten Multivibrators (T1, T2) liegt und das Sendebauteil (D1) am Kollektor des zweiten Transistors (T2') des zweiten Multivibrators (T1', T2') liegt, daß die Impulspausen des zweiten Multivibrators (T1', T2') kürzer sind als die am ersten Multivibrator (T1, T2) einstellbaren Impulspausen, und daß im Empfänger (V) ein Filter (C5, R16) vorgesehen ist, das auf die Impulsfrequenz des zweiten Multivibrators (T1', T2') abgestimmt ist.

**Claims**

1. Remote control circuit, especially infrared remote control circuit, for controlling a plurality of functions of a device, for example a toy vehicle or diapositive slide projector, comprising a transmitter (1) that can be switched on and off, which comprises a pulse generator and components (R3 to R6; R9 to R12) which determine a number of different pulse interval durations with unchanged pulse duration, this number corresponding to the number of the functions (A1 to A4) to be controlled, each of which components can be switched on by a switch (S1 to S4), and comprising a receiver (figure 2) which evaluates the pulse interval duration, the transmitter as multivibrator being constructed of two transistors (T1, T2), wherein the collector of the first transistor is connected to the base of the second transistor, the collector of which is connected via an RC-element (C2, R2) to the base of the first transistor (T1), and the components (R3 to R6; R9 to R12) which determine the pulse interval durations are connected to the base of the first transistor (T1), characterized in that the transmitter (1) is composed of complementary transistors (T1, T2) and that the transmitting component (D1) is connected to the collector of the second transistor (T2), each of the switches (S1 to S4) switching on and off the transmitter (1), that the receiver (figure 2) comprises an RC charging circuit (R7, C3), the capacitor (C3) of which charges during the pulse interval via its resistor (R7) and is discharged upon receipt of a transmission pulse, so that a sawtooth voltage (figure 3b, 4b) is produced, the periods of which correspond to the received pulse intervals (figure 3a, 4a) and the amplitude of which consequently corresponds to the pulse interval duration, and that behind the RC charging circuit (R7, C3) a filter stage (R8, C4) is connected, which forms a voltage level from the amplitudes of the sawtooth voltage, and that after the filter stage (R8, C4) a voltage level evaluator stage (JC) is connected, which controls one of the functions when the occurring voltage level corresponds to a voltage level from a number of voltage levels which corresponds to the number of the components which determine the pulse intervals.

2. Remote control circuit according to claim 1, characterized in that the components that determine the pulse intervals are resistors (R3 to R6) connected in parallel to the base of the first transistor (T1), with which resistors the switches (S1 to S4) are connected in series.

3. Remote control circuit according to claim 1, characterized in that the components that determine the pulse intervals are resistors (R9 to R12) connected in series to the base of the first transistor (T1) and that the switches (S1 to S4) are each connected between one of the resistors (R9 to R12) and the emitter of the second transistor (T2).

4. Remote control circuit according to one of the preceding claims, characterized in that the transmitter component is composed of one or more infrared diodes (D1, D1').

5. Remote control circuit according to one of the preceding claims, characterized in that an infrared diode (D1) is connected in series with a resistor (R1) to the collector of the second transistor (T2).

6. Remote control circuit according to one of the preceding claims, characterized in that, in the receiver, the collectoremitter path of a transistor (T3) is connected in parallel to the capacitor (C3) of the RC-charging circuit (R7, C3), to the base of which transistor the reception component (D2) is connected via a preamplifier (V).

7. Remote control circuit according to one of the preceding claims, characterized in that the transmitter (1) comprises a second multivibrator (T1', T2'), the base of the first transistor (T1') being connected via a resistor (R3') to the collector of the second transistor (T2) of the first multivibrator (T1, T2) and the transmitter component (D1) being connected to the collector of the second transistor (T2') of the second multivibrator (T1', T2'), that the pulse intervals of the second multivibrator (T1', T2') are shorter than the pulse intervals which can be set at the first multivibrator (T1, T2), and that a filter (C5, R16) is provided in the receiver (V), which filter is tuned to the pulse frequency of the second multivibrator (T1', T2').

**Revendications**

1. Circuit de télécommande, en particulier circuit de télécommande à infrarouge, pour la commande de plusieurs fonctions d'un appareil, par exemple d'un véhicule jouet ou d'un projecteur de diapositives, comportant un émetteur (1) pouvant être branché et débranché, qui présente un générateur d'impulsions et un nombre de composants (R3 à R6; R9 à R12) déterminant des durées différentes de pause d'impulsion avec une durée d'impulsion inchangée, nombre correspondant au nombre des fonctions à commander (A1 à A4), composants qui peuvent être branchés chacun au moyem d'un interrupteur (S1 à S4), comportant aussi un récepteur (figure 2) qui interprète la durée de pause d'impulsion, l'émetteur étant constitué comme un multivibrateur formé de deux transistors (T1, T2), dans lequel le collecteur du premier transistor est relié à la base du deuxième transistor dont le collecteur est relié par l'intermédiaire d'un élément RC (C2, R2) à la base du premier transistor (T1), et à la suite de la base du premier transistor (T1) sont raccordés les composants (R3 à R6; R9 à R12) déterminant la durée de pause d'impulsion, caractérisé en ce que l'émetteur (1) est constitué par des transistors complémentaires (T1, T2), en ce que le composant d'émission (D1) est relié au collecteur du deuxième transistor (T2), chacun des interrupteurs (S1 à S4) branchant ou débranchant l'émetteur (1), en ce que le récepteur (figure 2) présente un circuit de charge RC (R7, C3) dont le condensateur (C3) se charge pendant la pause d'impulsion par l'intermédiaire de sa résistance (R7) et se décharge lors de la réception d'une impulsion d'émission, de sorte qu'il se produit une tension en dents de scie (figures 3b, 4b) dont les périodes correspondent aux pauses d'impulsion reçues (figures 3a, 4a) et dont l'amplitude correspond, par exemple, a la durée de pause d'impulsion, et qu'à la suite du circuit de charge RC (R7, C3) est branché un étage de filtrage (R8, C4) qui forme, en partant des amplitudes de la tension en dents de scie, un niveau de tension, et en ce qu'à la suite de l'étage de filtrage (58, C4) est branché un étage d'interprétation de niveau de tension (JC) qui commande l'une des fonctions chaque fois que le niveau de tension qui règne correspond à un niveau de tension formé d'un nombre de niveaux de tension qui correspond au nombre des composants déterminant les pauses d'impulsion.

2. Circuit de télécommande selon la revendication 1, caractérisé en ce que les composants déterminant les pauses d'impulsion sont des résistances (R3 à R6) reliées en parallèles à la base du premier transistor (T1) et auxquelles les interrupteurs (SI à S4) sont reliés en série.

3. Circuit de télécommande selon la revendication 1, caractérisé en ce que les composants déterminant les pauses d'impulsion sont des résistances (R9 à R12) reliées en série à la base du premier transistor (T1), et en ce que les interrupteurs (S1 à S4) sont situés chacun entre l'une des résistances (R9 à R12) et l'émetteur du deuxième transistor (T2).

4. Circuit de télécommande selon l'une des revendications précédentes, caractérisé en ce que le composant d'émission est formé d'une ou de plusieurs diodes à infrarouge (D1, D1').

5. Circuit de télécommande selon l'une des revendications précédentes, caractérisé en ce qu'au collecteur du deuxième transistor (T2) est reliée en série une diode à infrarouge (D1) avec une résistance chutrice (R1).

6. Circuit de télécommande selon l'une des revendications précédentes, caractérisé en ce que dans le récepteur est placé, en parallèle au condensateur (C3) du circuit de charge RC (R7, C3), le parcours collecteur-émetteur d'un transistor (T3) à la base duquel est relié, par l'intermédiaire d'un préamplificateur (V), le composant de réception.

7. Circuit de télécommande selon l'une des revendications précédentes, caractérisé en ce que l'émetteur (1) comprend un deuxième multivibrateur (T1', T2'), la base du premier transistor (T1') étant reliée, par l'intermédiaire d'une résistance (R3'), au collecteur du deuxième transistor (T2) du premier multivibrateur (T1, T2) et le composant d'émission (DI) étant relié au collecteur du deuxième transistor (T2') du deuxième multivibrateur (T1', T2'), en ce que les pauses d'impulsion du deuxième multivibrateur (T1', T2') sont plus courtes que les pauses d'impulsion pouvant être établies au premier multivibrateur (T1, T2), et en ce que dans le récepteur (V) est prévu un filtre (C5, R16) qui est accordé sur la fréquence d'impulsion du deuxième multivibrateur (T1', T2').

## Fig. 1

## Fig.2

290  1/3

## Fig.3

a)   b)   c)

## Fig.4

a)   b)   c)

## Fig.5

290 2/3

3

## Fig. 6

## Fig. 7